# EUROPEAN PATENT SPECIFICATION

(11) **EP 0 449 553 B1**
(45) Date of publication and mention of the grant of the patent: **25.05.1994**
(21) Application number: 91302580.5
(22) Date of filing: 25.03.1991
(51) Int. Cl.: H01S 3/19

(54) **Semiconductor lasers**
Halbleiterlaser
Lasers à semi-conducteur

(30) Priority: 27.03.1990 JP 77976/90
(43) Date of publication of application: 02.10.1991
(73) Proprietor: SONY CORPORATION, Tokyo 141 (JP)
(72) Inventor: Yamamoto, Tadashi, c/o Patents Division, Shinagawa-ku, Tokyo 141 (JP); Ikeda, Masao, c/o Patents Division, Shinagawa-ku, Tokyo 141 (JP); Mikata, Yasue, c/o Patents Division, Shinagawa-ku, Tokyo 141 (JP)
(74) Representative: Thomas, Christopher Hugo

(56) References cited:
- EP-A- 0 234 955
- EP-A- 0 334 637
- PATENT ABSTRACTS OF JAPAN vol. 14, no. 2 (E-868) 8 January 1989 & JP-A-1 251 684
- ELECTRONICS LETTERS vol. 23, no. 18, 27August 1987, STEVENAGE, HERTS., GB, pages 938 - 939; H. FUJII ET AL.: 'HIGH POWER OPERATION OF A TRANSVERSE-MODE STABILISED ALGAINP SEMICONDUCTOR LASER'
- PATENT ABSTRACTS OF JAPAN vol. 12, no. 324 (E-653) 2 September 1988 & JP-A-63 090 186
- PATENT ABSTRACTS OF JAPAN vol. 11, no. 148 (E-506) 14 May 1987 & JP-A-61 285 783

## Description

This invention relates to semiconductor lasers.

Visible-light semiconductor lasers composed of AlGaInP have been attracting particular attention recently as a light source for optical information processing, and development is currently in progress to realize a lower threshold value and lateral mode control for practical use.

We have proposed in our Japanese laid-open patent specification 62/26885 a semiconductor laser of AlGaInP, wherein a p-type cladding layer on a side to be attached to a header or a heat sink is formed into a dual layer structure (hereinafter referred to as DSC structure) which consists of an AlGaInP layer and an AlGaAs layer of high thermal conductivity so as to enhance the heat radiation effect.

For the purpose of lowering the threshold value in the semiconductor laser, there is provided a ridge pattern wherein both sides of the semiconductor layer adjacent to the p-type cladding layer on the active layer are removed by etching, while a central portion thereof is left unremoved in the shape of a stripe, and an n-type current stricture layer is formed in the removed portion by epitaxial growth.

If this DSC structure is applied to a semiconductor laser with such dridge pattern, manufacture of the ridge-shaped region is improved.

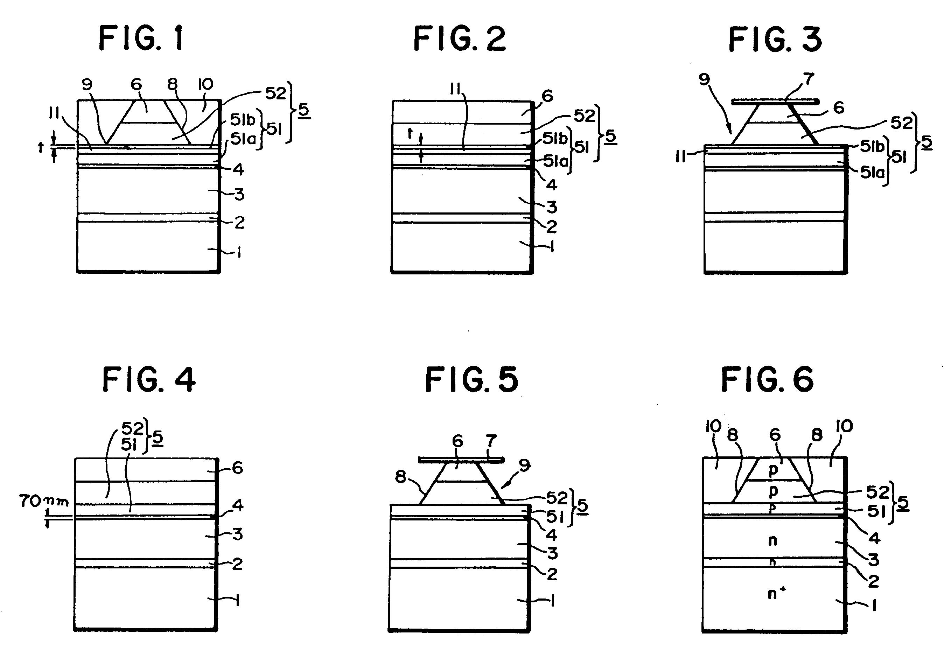

More specifically, in a semiconductor laser having the above DSC structure as shown in a sectional view in Figure 4, there are sequentially formed an n-type buffer layer 2 of GaAs, an n-type cladding layer 3 of AlGaInP, a non-doped active layer 4, a p-type cladding layer 5 and a cap layer 6, on a semiconductor substrate 1 which is composed of n-type GaAs or the like having a high impurity concentration with its [100] crystal plane used as a main surface. Furthermore, the p-type cladding layer 5 has a laminated structure consisting of a first cladding layer 51 of (AlₓGa₁₋ₓ)InP disposed on the active layer 4, and a second cladding layer 52 of Al_{y}Ga_{1-y}As disposed on the first cladding layer.

When the ridge pattern is employed in a semiconductor laser of such DSC structure, as shown in a schematic sectional view of Figure 5 representing a process for manufacture of the semiconductor laser, first a striped mask 7 of SiNₓ or the like is deposited on a central portion of the cap layer 6, and an etching step is executed from the side of the cap layer 6 by the use of the mask 7 and an etching liquid of sulphuric acid. As a result of such step, the etching in progress is apparently brought to a halt at the time when the first cladding layer 51 of AlGaInP, on which the corrosive action speed of the etching liquid of sulphuric acid is extremely low, is exposed. Therefore, if the etching step is interrupted at such time, merely the cap layer 6 and the second cladding layer 52 of the p-type cladding layer 5 are selectively etched at both sides thereof which are not covered with the mask 7. In this stage, the etching is effected with the liquid entering under the two side edges of the mask 7, and the lateral surface 8 formed by such etching becomes a [111]A crystal surface.

Thereafter, as shown in a schematic sectional view of Figure 6 (representing a state after completion of an under-mentioned current stricture layer 10 and subsequent withdrawal of the mask 7), an n-type current stricture layer 10 of GaAs is selectively formed, while being covered with the mask 7, in the etch-removed portion 9 by epitaxial growth based on a metalorganic chemical vapour deposition (MOCVD) process. However, due to the existence of As on the lateral surface 8 and the existence of P on the [100] crystal surface of the first cladding layer 51 formed by the etching, it is difficult to attain selective epitaxial growth completely with high reproducibility on both of these surfaces. Furthermore, since heat is applied up to 720°C or so during such epitaxial growth, P contained in the first cladding layer 51 is evaporated consequently to deteriorate the characteristics thereof, hence raising another problem in manufacture of a high-reliability element.

According to the present invention there is provided a semiconductor laser formed into a double hetero- junction structure comprising an n-type cladding layer and a p-type cladding layer with an active layer interposed therebetween;
wherein said p-type cladding layer has a laminated structure consisting of a first cladding layer of (AlₓGa₁₋ₓ)InP disposed on said active layer and a second cladding layer of Al_{y}Ga_{1-y}As disposed on said first cladding layer;
said second cladding layer has been partially removed, and a current stricture layer of GaAs has been formed in place of said removed portion on said first cladding layer;
characterized by:
said first cladding layer comprising two layer portions with a deterioration preventive layer of AlₓGa_{1-z}As sandwiched therebetween at a position spaced apart from said second cladding layer by a predetermined distance and of a thickness to prevent evaporation of P from the underlying said layer portion of said first cladding layer without impairing the confinement function of said active layer, the overlying said layer portion of said first cladding layer being thin enough to allow complete evaporation of P from said overlying layer portion during formation of said current stricture layer, without impairing its etch-stop function during the said partial removal of the said second cladding layer..

In the compositions of the individual layers, x, y and z represent atomic ratios which are preferably defined as 0.5 ≦ x ≦ 1, 0.6 ≦ y ≦ 1, and 0.6 ≦ z ≦ 1.

In an embodiment of the present invention adopting a DSC structure, the second cladding layer of AlGaAs having a high thermal conductivity is included in the p-type cladding layer, so that a satisfactory heat radiation effect is attainable by attaching the semiconductor laser to a header or a heat sink at the p-type cladding layer side thereof. During the selective etching executed to form the current stricture layer, the first cladding layer of AlGaInP is capable of serving as a stopper against the selective etching, whereby the etching up to a predetermined position can be controlled with certainty.

In the first cladding layer of such an embodiment, there is included the deterioration preventive layer of Al_{z}Ga_{1-z}As which has the effect of blocking P. Consequently such deterioration preventive layer is capable of checking evaporation of P from the principal first cladding layer of the first cladding layer on one side adjacent to the active layer, thereby preventing both deterioration of the cladding layer characteristics and deterioration of the crystallinity.

In such an embodiment, the surface of the first cladding layer containing P as a stopper against the etching may be formed opposite to the removed portion etched for forming the current stricture layer, and such surface may be composed of a sufficiently thin layer due to the existence of the deterioration preventive layer, so that P contained in the thin-film layer is mostly evaporated or turned into AsP by the heat applied during the epitaxial growth in forming the current stricture layer. Consequently, it becomes possible to prevent the disadvantage that satisfactory epitaxial growth is impeded as mentioned by the residual P existent formerly in the removed portion.

Thus a high-reliability semiconductor laser retaining a low threshold value can be realized with superior reproducibility.

The invention will now be described by way of example with reference to the accompanying drawings, throughout which like parts are referred to by like references, and in which:
Figure 1 is a schematic view of an embodiment of semiconductor laser according to the present invention;
Figures 2 and 3 illustrate steps in the process of manufacturing such a semiconductor laser; and
Figures 4 to 6 illustrate steps in the process of manufacturing a previously proposed semiconductor laser.

First, as illustrated in a schematic sectional view of Figure 2, a plurality of layers are sequentially formed on a semiconductor substrate 1, which is composed of n-type GaAs or the like of a high impurity concentration and has a main surface of [100] crystal plane, with epitaxial growth effected by a continuous MOCVD process. Such plurality of layers includes a buffer layer 2 composed of n-type GaAs and having a thickness of 0.3 µm or so; a cladding 3 composed of n-type AlGaInP and having a thickness of 1.5 µm or so; an active layer 4 composed of non-doped GaInP and having a thickness of 70nm or so; a p-type cladding layer 5; and a cap layer 6 having a thickness of 0.8 µm or so. In particular, the p-type cladding layer 5 has a laminated structure consisting of a first cladding layer 51 of (AlₓGa₁₋ₓ)InP disposed on the active layer 4 and having a thickness of 0.3 µm or so, and a second cladding layer 52 of Al_{y}Ga_{1-y}As disposed on the first cladding layer and having a thickness of 0.8 µm or so. In addition thereto, a deterioration preventive layer 11 of Al_{z}Ga_{1-z}As is included in the first cladding layer 51 at a position spaced apart by a predetermined small thickness t from the second cladding layer 52. More specifically, the first cladding layer 51 consists of a principal first cladding layer 51a adjacent to the active layer 4, the deterioration preventive layer 11, and a thin-film first cladding layer 51b of a thickness t superimposed sequentially.

The n-type cladding layer 3 is composed of n-type (AlₓGa₁₋ₓ)InP (where 0.5 ≦ x ≦ 1) such as (Al_{0.5}Ga_{0.5})_{0.5} In_{0.5}P for example; the active layer 4 is composed of non-doped Ga_{0.5}In_{0.5}P for example; the principal first cladding layer 51a and the thin-film first cladding layer 51b of the first cladding layer 51 in the p-type cladding layer 5 are both composed of p-type (AlₓGa₁₋ₓ)InP (where 0.5 ≦ x ≦ 1), such as (A1_{0.5}Ga_{0.5})_{0.5}In_{0.5}P for example; and the deterioration preventive layer 11 and the second cladding layer 52 are composed of p-type Al_{z}Ga_{1-z}As and p-type Al_{y}Ga_{1-y}As respectively (where 0.6 ≦ z ≦ 1, 0.6 ≦ y ≦ 1), such as A1_{0.6}Ga_{0.4}As for example.

In forming each layer by a MOCVD process, H₂Se may be used as an n-type impurity source, and DMZn as a p-type impurity source.

The thickness of the deterioration preventive layer 11 is selectively set in a range of 5 to 100nm. Such selective setting is based on the facts that any thickness less than 5nm is not effective for completely preventing evaporation of P from the principal first cladding layer 51a, and any thickness exceeding 100nm impairs the essential confinement function to the active layer 4.

Meanwhile the thickness t of the thin-film first cladding layer 51b in the first cladding layer 51 is selectively set in a range of 3 to 10nm. Such selective setting is based on the facts any thickness less than 3nm is insufficient for exerting the function as an etching stopper, and any thickness exceeding 10nm causes residual phosphorus P on the surface of the current stricture layer 10 during its epitaxial growth and therefore impairs satisfactory epitaxial growth of the current stricture layer 10.

Subsequently, as illustrated in a schematic sectional view of Figure 3, a striped mask 7 of SiNₓ or the like is deposited on a central portion of the cap layer 6, and an etching step is executed from the side of the cap layer 6 by the use of such mask 7 and an etching liquid of sulphuric acid. Then the etching in progress is apparently brought to a halt at the time when the first cladding layer 51 of AlGaInP, where the corrosive action speed of the etching liquid of sulphuric acid is extremely low, has been exposed to the outside. therefore, if the etching is interrupted at such time, merely the cap layer 6 and the second cladding layer 52 of the p-type cladding layer 5 are selectively etched at both sides thereof which are not covered with the mask 7. In this stage, the etching is effected with the liquid entering under the two side edges of the mask 7, and the lateral surface 8 formed by such etching becomes a [111] A crystal surface.

Thereafter, as shown in a schematic sectional view of Figure 1, a current stricture layer 10 of n-type GaAs is formed, while being covered with the mask 7, in the etch-removed portion 9 by selective epitaxial growth based on the MOCVD process. Figure 1 illustrates a state after withdrawal of the mask 7.

In the embodiment mentioned, Se is used as an n-type impurity and Zn as a p-type impurity, respectively. However, it is to be understood that the impurities are not limited to such examples alone and may be Si, Mg and so forth as well. Thus, a variety of changes and modifications may be adopted without being restricted to the above embodiment.

According to the above-described embodiment of the present invention where a DSC structure is adopted, the second cladding layer 52 of AlGaAs having a high thermal conductivity is included in the p-type cladding layer 5, so that satisfactory heat radiation effect is attainable by attaching the semiconductor laser to a header or a heat sink at the p-type cladding layer side thereof. Furthermore, during the selective etching executed to form the current stricture layer 10, the first cladding layer 51b of (AlₓGa₁₋ₓ)InP (where 0.5 < x < 1) is capable of retaining the function as a stopper against the selective etching, whereby the etching up to a predetermined position can be controlled with certainty.

In addition, the deterioration preventive layer 11 of Al_{z}Ga_{1-z}As is included in the first cladding layer 51, and such material Al_{z}Ga_{1-z}As is effective for blocking P, thereby checking evaporation of the phosphorus P from the principal first cladding layer 51a of the first cladding layer 51 on one side adjacent to the active layer 4. Consequently it becomes possible to avert deterioration of the cladding layer crystallinity.

In the embodiment of the present invention, the surface of the first cladding layer 51 containing P as a stopper against the etching is formed opposite to the removed portion 9 etched for forming the current stricture layer 10, and such surface is composed of a sufficiently thin layer 51b having a thickness t, so that P contained in such thin-film layer is mostly evaporated or turned into AsP by the heat applied before and during the epitaxial growth in forming the current stricture layer 10, hence averting the aforementioned disadvantage that adequate epitaxial growth is impeded by the residual phosphorus existent formerly in the removed portion 9.

## Claims

1. A semiconductor laser formed into a double hetero- junction structure comprising an n-type cladding layer (3) and a p-type cladding layer (5) with an active layer (4) interposed therebetween; wherein said p-type cladding layer (5) has a laminated structure consisting of a first cladding layer (51) of (AlₓGa₁₋ₓ)InP disposed on said active layer (4) and a second cladding layer (52) of Al_{y}Ga_{1-y}As disposed on said first cladding layer (51); and
said second cladding layer (52) has been partially removed, and a current stricture layer (10) of GaAs has been formed in place of said removed portion on said first cladding layer (51);
characterized by:
said first cladding layer (51) comprising two layer portions (51a, 51b) with a deterioration preventive layer (11) of Al_{z}Ga_{1-z}As sandwiched therebetween at a position spaced apart from said second cladding layer (52) by a predetermined distance and of a thickness such as to prevent evaporation of P from the underlying said layer portion (51a) of said first cladding layer (51) without impairing the confinement function of said active layer (4), the overlying said layer portion (51b) of said first cladding layer (51) being thin enough to allow complete evaporation of P from said overlying layer portion (51b) during formation of said current stricture layer (10), without impairing its etch-stop function during the said partial removal of the said second cladding layer..

2. A laser according to claim 1 wherein x, y and z representing the atomic ratios in the compositions are defined as 0.5 ≦ x ≦ 1, 0.6 ≦ y ≦ 1, and 0.6 ≦ z ≦ 1, respectively.

3. A laser according to claim 1 or claim 2 wherein the thickness of said overlying layer portion (51b) is in a range of 3 to 10nm.

4. A laser according to claim 1, claim 2 or claim 3 wherein the thickness of said deterioration preventive layer (11) is in a range of 5 to 100nm.

## Patentansprüche

1. Halbleiterlaser, der in einer Doppelheterostruktur (DH-Struktur) gebildet ist, die eine n-Deckschicht (3) und eine p-Deckschicht (5) mit einer dazwischen angeordneten Aktivschicht (4) aufweist; wobei die p-Deckschicht (5) eine laminierte Struktur aufweist, die aus einer ersten Deckschicht (51) aus (AlₓGa₁₋ₓ) InP besteht, die auf der Aktivschicht (4) aufgebracht ist, und aus einer zweiten Deckschicht (52) aus Al_{y}Ga_{1-y}As, die auf der ersten Deckschicht (51) aufgebracht ist; und
wobei die zweite Deckschicht (52) teilweise entfernt wurde und eine Stromeinschnürungsschicht (10) aus GaAs anstelle des entfernten Teils auf der ersten Deckschicht (51) gebildet wurde;
**dadurch gekennzeichnet,**
daß die erste Deckschicht (51) zwei Schichtteile (51a, 51b) mit einer Verschlechterungs-Schutzschicht (11) aus Al_{z}Ga_{1-z}AS aufweist, die dazwischen angeordnet ist an einer Position, die von der zweiten Deckschicht (52) um einen vorgegebenen Abstand beabstandet ist, und eine solche Dicke aufweist, um ein Verdampfen von P aus dem unten liegenden Schichtteil (51a) der ersten Deckschicht (51) zu verhindern, ohne die Sperrfunktion der Aktivschicht (4) zu beeinträchtigen, wobei der oben liegende Schichtteil (51b) der ersten Deckschicht (51) dünn genug ist, um ein vollständiges Verdampfen von P aus dem oben liegenden Schichtteil (51b) während der Bildung der Stromeinschnürungsschicht (10) zu erlauben, ohne ihre Ätzstoppfunktion während des teilweise Entfernens der zweiten Deckschicht zu beeinträchtigen.

2. Laser nach Anspruch 1, wobei x, y und z, die die Atomverhältnisse in den Verbindungen darstellen, festgelegt sind zu 0,5 ≦ x ≦ 1, 0,6 ≦ y ≦ 1 bzw. 0,6 ≦ z ≦ 1.

3. Laser nach Anspruch 1 oder 2, wobei die Dicke des oben liegenden Schichtteils (51b) in der Größenordnung von 3 bis 10 nm liegt.

4. Laser nach Anspruch 1, 2 oder 3, wobei die Dicke der Verschlechterungs-Schutzschicht (11) in der Größenordnung von 5 bis 100 nm liegt.

## Revendications

1. Un laser à semi-conducteur, formé dans une structure d'hétéro-jonction double, comprenant une couche d'emprisonnement optique (3) du type n et une couche d'emprisonnement optique (5) du type p entre lesquelles une couche active (4) est interposée; dans lequel ladite couche d'emprisonnement optique (5) du type p comporte une structure stratifiée, consistant en une première couche d'emprisonnement optique (51) de (AlₓGa₁₋ₓ)InP disposée sur ladite couche active (4) et une seconde couche d'emprisonnement optique (52) de Al_{y}Ga_{1-y}As disposée sur ladite première couche d'emprisonnement optique (51); et
ladite seconde couche d'emprisonnement optique (52) a été partiellement enlevée, et une couche (10) de limitation de courant de GaAs a été formée, à la place de ladite partie enlevée, sur ladite première couche d'emprisonnement optique (51);
**caractérisé en ce que :**
ladite première couche d'emprisonnement optique (51), comprend deux parties de couche (51a, 51b) entre lesquelles une couche (11) de prévention de détérioration de Al_{z}Ga_{1-z}As est intercalée, en une position écartée, par rapport à ladite seconde couche d'emprisonnement optique (52), d'une distance prédéterminée, et possédant une épaisseur telle que l'évaporation de P en provenance de ladite partie de couche sous-jacente (51a) de ladite première couche d'emprisonnement optique (51) est évitée sans affecter la fonction de confinement de ladite couche active (4), ladite partie de couche sus-jacente (51b) de ladite première couche d'emprisonnement optique (51) étant suffisamment mince pour permettre l'évaporation complète de P en provenance de ladite partie de couche sus-jacente (51b) au cours de la formation de ladite couche (10) de limitation de courant sans affecter sa fonction d'arrêt d'attaque au cours dudit enlèvement partiel de ladite seconde couche d'emprisonnement optique.

2. Un laser selon la revendication 1, dans lequel x, y et z, représentant les rapports atomiques dans les compositions, sont définis, respectivement, ainsi : 0,5 ≦ x ≦ 1, 0,6 ≦ y ≦ 1, et 0,6 ≦ z ≦ 1.

3. Un laser selon l'une quelconque des revendications 1 et 2, dans lequel l'épaisseur de ladite partie de couche sus-jacente (51b) se trouve dans une gamme de 3 à 10nm.

4. Un laser selon l'une quelconque des revendications 1, 2 et 3, dans lequel l'épaisseur de ladite couche de prévention de détérioration (11) se trouve dans une gamme de 5 à 100nm.
